(19)

Europäisches
Patentamt
European
Patent Office
Office européen
des brevets

(11) **EP 4 782 924 A1**

(12) **EUROPEAN PATENT APPLICATION**

(43) Date of publication:
**29.07.2026 Bulletin 2026/31**

(21) Application number: **25154435.9**

(22) Date of filing: **28.01.2025**

(51) International Patent Classification (IPC):
*G03F 9/00* (2006.01)

(52) Cooperative Patent Classification (CPC):
**G03F 9/7034**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
- **GOORDEN, Sebastianus, Adrianus
  Veldhoven (NL)**
- **DONKERBROEK, Arend, Johannes
  Veldhoven (NL)**
- **PASSARIELLO JANSEN, Juliette Marie
  Veldhoven (NL)**

(74) Representative: **ASML Netherlands B.V.
Corporate Intellectual Property
P.O. Box 324
5500 AH Veldhoven (NL)**

(54) **METHOD FOR DETERMINING CORRECTION WEIGHTS**

(57) The present invention provides a method for determining a set of correction weights to correct data relating to height measurements of a substrate comprising a plurality of fields to be exposed, the method comprising: obtaining height data relating to a plurality of illumination settings of measurement radiation used to perform a measurement, where each illumination setting comprises a different wavelength, polarization, angle of incidence, or any combination thereof; and determining at least one of: a) one or more correction weights to minimize variation of intrafield height data, and/or b) one or more correction weights such that the height data across the plurality of fields is largely equivalent.

Fig. 3

$W_1 \times$ $(\lambda_1)$ $+W_2 \times$ $(\lambda_2)$ $+W_3 \times$ $(\lambda_3)$ $=$

**Description**

FIELD

The present invention relates to methods for determining a set of correction weights for data relating to height measurements of a substrate, a level sensor and a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

It may be useful to obtain height measurements of a substrate, for example, to subsequently correct the position of a substrate during pattern transfer. Known sensors, such as a level sensor (e.g. using ultraviolet light) can be used for measurement of a height map of a substrate. There is room for improving the accuracy of measurements obtained by such a sensor due to the rapidly increasing numerical aperture (NA) constraints led by EUV technology and decreasing scanner focus depth.

SUMMARY

In the present invention, a method is provided for determining a set of correction weights to correct data relating to height measurements of a substrate comprising a plurality of fields to be exposed, the method comprising: obtaining height data relating to a plurality of illumination settings of measurement radiation used to perform a measurement, where each illumination setting comprises a different wavelength, polarization, angle of incidence, or any combination thereof; and determining at least one of: a) one or more correction weights to minimize intrafield height data, and/or b) one or more correction weights such that the height data across the plurality of fields is largely equivalent.

In the present invention, a level sensor is provided to perform the method described herein.

In the present invention, a lithographic apparatus is provided comprising: a patterning device support for supporting a patterning device; a substrate support for supporting a substrate; and the level sensor.

In the present invention, a computer program is provided comprising program instructions operable to perform the methods described herein.

In the present invention, a processing system is provided comprising a processing and a storage device comprising the computer program.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a level or height sensor; and
- Figure 3 depicts a schematic illustration of three weighted colourmaps combined to create a corrected height map (wafermap).

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

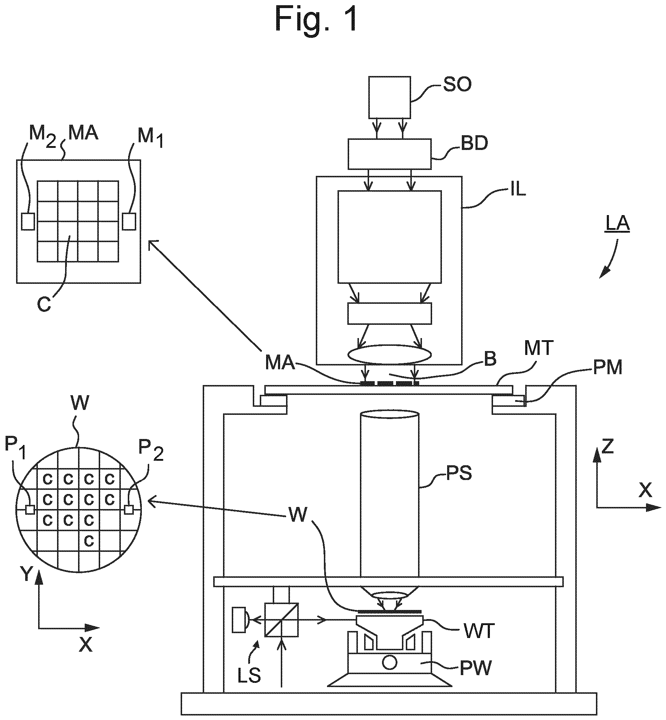

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

The lithographic apparatus may comprise a sensor LS used for e.g. measuring the topography of a top surface of the substrate. Sensor LS may be disposed in the vicinity of substrate support WT so that it may measure a property of the substrate. Sensor LS may use light emitted by a source, e.g. a laser-pumped plasma source LPPS (e.g. UV light).

A topography measurement system, level sensor or height sensor (such as the sensor LS) may be integrated in the lithographic apparatus and may be arranged to measure a topography of a top surface of the substrate. A map of the topography of the substrate, also referred to as height map or wafermap, may be generated from these measurements indicating a height of the substrate as a function of the position on the substrate. This height map may subsequently be used to correct the position of the substrate during transfer of the pattern on the substrate, in order to provide an aerial image of the patterning device in a properly focused position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

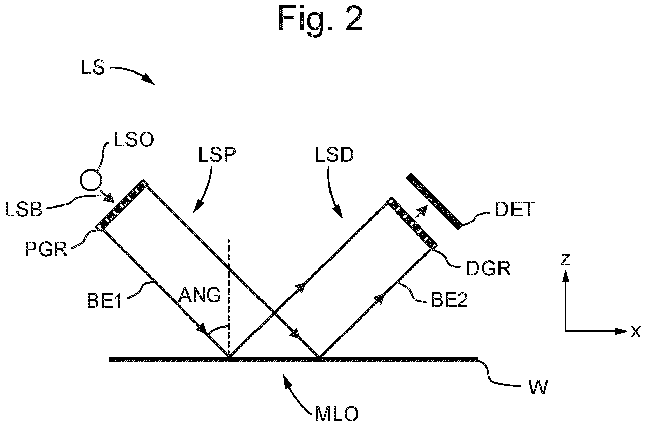

An example of a level or height sensor LS as known in the art is schematically shown in Figure 2, which illustrates only the principles of operation. In this example, the level sensor LS comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband radiation source, such as a supercontinuum light source, polarized or non-polarized, pulsed or continuous, such as a polarized or non-polarized laser beam. The radiation source LSO may include a plurality of radiation sources having different colours, or wavelength ranges, such as a plurality of LEDs and/or LPPS. The radiation source LSO of the level sensor LS is not restricted to visible radiation, but may additionally or alternatively encompass UV (ultra-violet) and/or IR (infra-red) radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127AI, incorporated by reference, a compact height sensor is described which uses a multi-element detector to detect and recognize the position of a grating image, without needing a detection grating. Other kinds of height sensor, including those which no not utilize triangulation techniques may be used.

When measuring the height of the substrate, the sensor (e.g. a level sensor) can be used to measure interfield data and intrafield data. Interfield data provides information of height distribution over the substrate, while intrafield data provides height distribution over the field (wherein there are many fields over a substrate). The intrafield is a fingerprint derived from a plurality of fields, and may for example represent a mean field. As each field is exposed with the same pattern, in theory each field should show the same height information. However, this may not be the case, and therefore there are height variations of the intrafield.

As described above, it is beneficial to improve the accuracy of the height measurements obtained by a sensor (e.g. by the level sensor). The measured height comprises true height information and erroneous information resulting from height process dependency (HPD). Height process dependency is a phenomenon where reflections from underlying layers cause errors in the measured height. True height information does not rely on a colour recipe for measurement (e.g. wavelength cut-off and/or colour weights, etc.), but HPD effects strongly depend on colour recipes. Deciding on a good colour recipe (wavelength cut-off and/or colour weights, etc.) may be relatively straightforward when reliable reference data is available. However, it is more convenient if the colour recipe can also be obtained, and preferably optimized, without requiring reference data.

The present invention provides a method of obtaining a "colour recipe" for processing of data relating to height measurements. Preferably, the method provides a way of determining correction weights (i.e. which can be used as part of a colour recipe) to reduce height process dependency (HPD).

Known approaches are in use or have been proposed to determine a colour recipe comprising correction weights (for example, US publication US2019/0094721 A1 which uses colour weighting and is incorporated herein by reference in its entirety). Such known approaches may rely on the use of reference data for initially determining the correction weights. This means that these corrections can only be accurately performed if sufficient reference data is available and if the process variations in the reference data are representative of the variations that need to be corrected. This reference data may be measured by a reference sensor after a substrate has been exposed. There are important drawbacks to using measurements obtained in this way. For example, such measurements may be expensive, not all exposed wafers are typically measured, and measurements take place a relatively long time after exposure such that corrections may be out-of-date by the time they are applied.

Thus, although determining a good colour recipe may be relatively "easy" when reliable reference data from a metrology tool, such as SEM, is available, it may be more convenient for the user if the colour recipe can also be obtained, or even optimized, without requiring such reference data. Preferably, the method provides a way of determining correction weights without requiring a user to obtain/provide reference measurements.

It is therefore proposed to obtain a colour recipe using only height data, e.g., without relying on external metrology feedback (at least for obtaining an initial colour recipe, i.e. initial correction weights). The proposed method is based on an observed correlation between optimising the colour recipe to reduce height data residuals (the difference between measured height data and the model fitted to the height data) and reduced error in the measured height information (i.e. reduced height process dependency). Due to variations in the underlying layers causing errors in the measured height, each colour measures a slightly different height, and the colour which best fits the model may be chosen as the recipe colour. This concept may be extended to determine a colour weighting for multiple colours, in a manner similar to US2019/0094721 A1, but without reliance on reference focus data. For the avoidance of doubt, all references to "a colour" in this disclosure should be understood to encompass (and be shorthand for) a particular wavelength, polarization and angle of incidence combination.

The method of the present invention comprises determining a set of correction weights to correct data relating to height measurements of a substrate comprising a plurality of fields to be exposed. The set of correction weights may provide, i.e. may be part of or may form, the colour recipe. The colour recipe optionally comprises additional components, which may provide further improvement, such as colour tuning (i.e. wavelength cut-off), which is described further below.

The method comprises obtaining height data relating to a plurality of illumination settings of measurement radiation used to perform a measurement, where each illumination setting comprises a different wavelength, polarization, angle of incidence, or any combination thereof. The height data across a substrate may be referred to as a wafermap. Thus, for each colour, a wafermap can be obtained. The method may comprise carrying out the measurements to obtain the wafermap. Thus, the wafermap is obtained for each particular wavelength, polarization and angle of incidence combination.

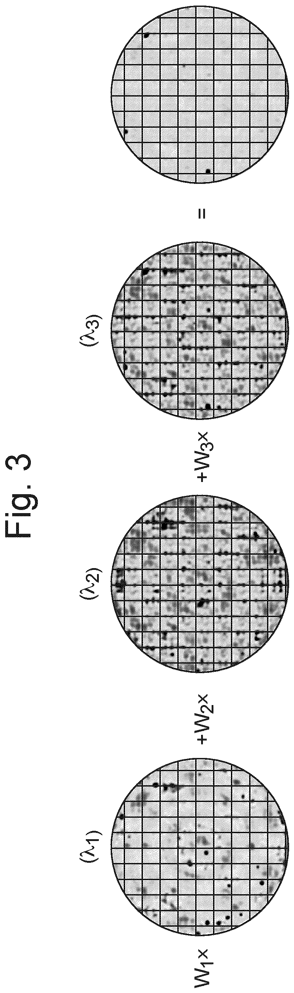

In Figure 3 (which is provided as an example for the purposes of explanation only), a first wafermap is obtained with a first wavelength $\lambda 1$, a second wafermap is associated with a second wavelength $\lambda 2$ and a third wafermap is associated with a third wavelength $\lambda 3$. Each wavelength is also associated with one of two polarizations. Each wafermap corresponds on one colour n. Each wafermap is given a weighting factor $w_n$ where n is the $n^{th}$ map. The sum of all weighted wafermaps provides a corrected wafermap (shown on the right hand side of figure 3).

Weighting factors (colour weights) $w_n$ may be determined by a least squares fit method which minimizes fit residuals. As described in further detail below, the method may comprise fitting the height data for each illumination setting to a model for representing the height data, determining the fit residuals, and determining said correction weights as correction weights which minimize the fit residuals (although other optimization methods are available).

In a first embodiment of the invention, colours are weighted such that intrafield height variations are minimized. Thus, in the first embodiment, the method comprises determining one or more correction weights to minimize intrafield height variations. In other words, correction weights are determined such that the weighted sum of all intrafield has minimal

variation.

Colour weights $w_n$ for colours n (of a total number of colours N) which, when applied to wafermap data $m_{meas}$ (respective wafermap for each colour), yields a height-corrected wafermap $m_{corr}$:

$$m_{corr} = \sum_{n=1}^{N} w^{(n)} m_{meas}^{(n)}$$

To which an additional constraint may be imposed, that the sum of colour weights equals 1:

$$\sum_{n=1}^{N} w^{(n)} = 1$$

The goal of the proposed method is to determine a set of colour weights which minimizes a set of wafermap residuals, such that the colour weighted positions have lower (or at least the same) model residuals compared to the -colour measured position. The colour-measured position may be a single-colour measured position, or may be an average-colour measured position. The specific illustrative method described below determines this set of colour weights by performing a linear least squares optimization of the wafermap residuals for each measurement. However, it should be appreciated that this is only one optimization option and alternative optimization methods may be performed instead. For instance, by including a regularization term in the optimization based on an L1 norm.

The method comprises obtaining height data comprising per-colour wafermaps (i.e., there are multiple wafermaps, one per colour). The wafermap residuals may be calculated for each height measurement in a wafermap (total M measurements) and for each colour (total N colours) by fitting the height measurements per colour with a leveling model, and recording the fit residuals. The leveling model may be any suitable model used for leveling and accordingly obtaining a height profile, for example a low-order interfield polynomial model, or for example a model based on low-order interfield and high-order intrafield fingerprints. The fit residuals can be represented as a residual matrix R, with each element comprising a residual $r_m^{(n)}$ on wafermap index m (where m= 1 to M) and colour channel n (where n= 1 to N):

$$R = \begin{bmatrix} r_1^{(1)} & r_1^{(2)} & ... & r_1^{(N)} \\ r_2^{(1)} & r_2^{(2)} & ... & r_2^{(N)} \\ r_3^{(1)} & r_3^{(2)} & ... & r_3^{(N)} \\ \vdots & \vdots & \ddots & \vdots \\ r_M^{(1)} & r_M^{(2)} & ... & r_M^{(N)} \end{bmatrix}$$

The residuals may be calculated over multiple wafers and stacked vertically in R.

The goal of the algorithm is to find a set of colour weights $\overline{w} = [w^{(1)} w^{(2)} ... w^{(N)}]^T$ which minimize the residuals R (e.g., in a least squares sense), i.e., to obtain:

$$R\overline{w} = \overline{0}$$

$$\begin{bmatrix} r_1^{(1)} & r_1^{(2)} & ... & r_1^{(N)} \\ r_2^{(1)} & r_2^{(2)} & ... & r_2^{(N)} \\ r_3^{(1)} & r_3^{(2)} & ... & r_3^{(N)} \\ \vdots & \vdots & \ddots & \vdots \\ r_M^{(1)} & r_M^{(2)} & ... & r_M^{(N)} \end{bmatrix} \begin{bmatrix} w^{(1)} \\ w^{(2)} \\ \vdots \\ w^{(N)} \end{bmatrix} = \begin{bmatrix} 0 \\ 0 \\ \vdots \\ 0 \end{bmatrix}$$

As stated above, this system of equations can be solved, for example via linear least squares regression under the additional constraint that the sum of colour weights equals 1:

$$\sum_{n=1}^{N} w^{(n)} = 1$$

This constraint ensures that the determined corrected height map (wafermap) is invariant to translation in all of the colours, and also to avoid the trivial solution where all weights equal 0.

Once this system of equations is solved, applying the resulting optimal weights w to the height data will result in minimal model residuals (e.g., minimal root sum square / root mean square of model residuals) over the (set of) wafer(s) considered in the input.

In the first embodiment, the method is used for minimizing the variation of intrafield height data. The method comprises obtaining an average of the height data across the plurality of fields, and determining the one or more correction weights for the average of the height data. More specifically, the $m_{meas}$ value used for each colour (for a given wafer) corresponds to an average of the measurements across the fields for measurements of that colour. The average may be determined by summing the height measurement for each field at a given location on the field, and dividing by the respective number of fields. All fields in turn converge towards the average field, thus variation in the intrafield height is minimised.

In a second embodiment of the invention, colours are weighted such that height data in interfield data are largely equivalent (i.e. height data across a plurality of fields is largely equivalent). In this case, the method may be similar to the first embodiment, except that the $m_{meas}$ value used for each colour (for a given wafer) corresponds to the height data as measured across all the fields, i.e. instead of inputting an average of the measured values. The method comprises using height data for the plurality of fields and determining the one or more correction weights across the plurality of fields. The process includes adjusting the measurement values prior to determining the fit residuals. In particular, the method comprises calculating an adjustment reference field based on a map of the height data across the plurality of fields, and the height data for the plurality of fields is adjusted by subtracting the adjustment reference field from each of the plurality of fields. In other words, the $m_{meas}$ value used for each colour (for a given wafer) corresponds to the height data as measured across all the fields wherein the adjustment reference field is removed. Thus, the same adjustment reference value may be subtracted from each given location on each field (i.e. each corresponding location for each field). Thus, in the second embodiment, the method comprises determining one or more correction weights such that the height data across the plurality of fields is largely equivalent.

In the second embodiment, the adjustment reference field may be an average field. Thus, the adjustment reference field may be determined by summing the height measurement for each field at a given location on the field, and dividing by the respective number of fields.

The method may obtain weights based on a combination of minimizing the variation of intrafield height data and making the interfield height data (across the plurality of fields) largely equivalent. In particular, the method may comprise using a merit function combination of weights used to minimize the variation of intrafield height data and weights used to make the interfield height data largely equivalent. Thus, the method may comprise combining the first and second embodiments, and in particular, applying a weight to the combination. This could be implemented by determining one or more first correction weights to minimize the variation of intrafield height data (for example, as described above), and determining one or more second correction weights such that the interfield height data is largely equivalent (for example, as described above), and then determining one or more third correction weights based on a weighted sum of the first and second correction weights. The weighting of each of the first correction weights and the second correction weights may be based on user input. In this case, the colour recipe would comprise the one or more third correction weights (which amounts to a weighted sum of the first and second correction weights).

The method may comprise adjusting the weights obtained over time based on further measurements carried out. For example, the methods described above may provide an initial set of correction weights. The method may comprise further steps of adjusting the initial correction weights. For example, the method may comprise obtaining additional height data from further substrates to update the initial correction weights to provide one or more adjusted correction weights. The adjusted correction weights are effectively updated weights which are obtained when additional information is available.

This way, variation in the layer thickness between substrates may be accounted for in the height measurement data used for obtaining the recipe. This means that the recipe may be more robust. In addition, this can enable a recipe that smoothly varies in time (instead of being fixed for all wafers or separately optimized for every individual wafer). This is especially applicable for hardware embodiments where colour recipe can be tuned in post-processing, for example, because hyperspectral detection is used and different colours and polarizations are measured on different detectors.

In an embodiment, the disclosed method of optimizing on residuals can also be combined (in a number of various ways which will apparent to the skilled person) with an optimization based on other measurements, i.e. based on reference data obtained from at least one reference sensor after the substrate has been exposed (for example, in line with the methods described in the prior art, such as in US2019/0094721 A1). For example, when only a small number of focus wafers are available, the optimization may be performed on the height data residuals only, as described in the embodiments or variations described herein. Later, once sufficient wafers are available, the method may smoothly transition to optimizing on the reference data instead (e.g., the difference between post-exposure measurements relating, for example, to focus). Thus, the method may comprise obtaining correction weights as in any of the embodiments or variation described herein (i.e. without use of reference data) to be used as initial correction weights, obtaining reference correction weights from reference data, and combining the initial correction weights with the reference correction weights based on a weighted sum to transition from the initial correction weights to the reference correction weights.

Weighting factors may be further adapted using intensity information. This enables the resulting corrected height map to account for reflectivity contributions. A more accurate height map is therefore obtained.

When detecting a combination of colours, it follows that a combination of intensities is also detected. No additional source is used for this as each colour has an intensity. Each intensity may be referred to as an intensity channel. Thus, the method may comprise obtaining intensity data for each of the illumination settings, and using the intensity data for determining the one or more correction weights, as described in further detail below. The intensity channels give rise to reflectivity maps of the wafer. So, for the level sensor, for each detected colour and polarization, the intensity is also detected, which provides reflectivity information. The reflectivity maps may be used in addition to further modify the weighting applied to the wafermaps. Thus, although determining weights based on intensity are generally described below, weights could additionally or alternatively be determined based on the reflectivity map.

A first set of weights $w^{(n)}$ for each colourmap can be determined as described above, while simultaneously determining a second set of weights $v^{(n)}$ (intensity asymmetry weights / reflectivity weights) for the intensity asummetry meausurements $Q_{meas}^{(n)}$. The weights $w^{(n)}$ and $v^{(n)}$ may be such that the corrected height map can be found by:

$$m_{corr} = \sum_{n=1}^{N} w^{(n)} m_{meas}^{(n)} + v^{(n)} Q_{meas}^{(n)} \quad.$$

Implementation of the method may comprise determining the set of colour weights $\overline{w}_I = [w^{(1)} + w^{(2)} \ldots w^{(N)} v^{(1)} v^{(2)} \ldots v^{(N)}]^T$ which minimize the residuals $\mathbf{R}_I$ (e.g., in a least squares sense):

$$\boldsymbol{R}_I \overline{w}_I = \overline{0}$$

$$\begin{bmatrix} r_1^{(1)} & r_1^{(2)} & \ldots & r_1^{(N)} & r_1^{I,(1)} & r_1^{I,(2)} & \ldots & r_1^{I,(N)} \\ r_2^{(1)} & r_2^{(2)} & \ldots & r_2^{(N)} & r_2^{I,(1)} & r_2^{I,(2)} & \ldots & r_2^{I,(N)} \\ r_3^{(1)} & r_3^{(2)} & \ldots & r_3^{(N)} & r_3^{I,(1)} & r_3^{I,(2)} & \ldots & r_3^{I,(N)} \\ \vdots & \vdots & \ddots & \vdots & \vdots & \vdots & \ddots & \vdots \\ r_M^{(1)} & r_M^{(2)} & \ldots & r_M^{(N)} & r_M^{I,(1)} & r_M^{I,(2)} & \ldots & r_M^{I,(N)} \end{bmatrix} \begin{bmatrix} w^{(1)} \\ w^{(2)} \\ \vdots \\ w^{(N)} \\ v^{(1)} \\ v^{(2)} \\ \vdots \\ v^{(N)} \end{bmatrix} = \begin{bmatrix} 0 \\ 0 \\ \vdots \\ 0 \\ 0 \\ 0 \\ \vdots \\ 0 \end{bmatrix}$$

Where $r_1^{I,(1)} - r_M^{I,(N)}$ are the intensity wafermap residuals. As before, m is the wafermap index (where m= 1 to M) and n is the colour channel index (where n= 1 to N). The basic methodology is the same as described in detail in relation to the first embodiment without intensity weighting, and can be applied to any of the embodiments or variations described herein..

A possible advantage of the methods disclosed herein is that no height training data is required. In other words, the initial set of the one or more correction weights determined in the present methods do not rely on any reference measurements. Furthermore, in in-line embodiments, height data can be corrected faster compared to correction based on height training wafers because the height data is available directly after the exposure. Thus, any change in process which requires re-training of the weights can be more quickly detected and addressed. In addition, this multi-colour lowest residual method shows a significant performance gain (in terms of improved height performance) compared to a single-colour residual approach and height-trained colour weighting methods.

Measuring the height data may also provide information on the global shape of the wafer, including any deformation of the wafer. Deformation of the wafer may occur by, for example, electrostatic clamping of the wafer to the substrate table and or heating of the substrate when the wafer is exposed to radiation. The method may include an initial step, i.e. prior to using the measurements to obtain the weight corrections, of removing data corresponding to a shape of the substrate from the height data. Thus, the overall shape of the wafer may be determined using known methods (for example, showing an overall tilt in the wafer out of the X-Y plane, i.e. in the Z direction) which may be removed from the height data prior to determining the weight corrections.

In general, the set of colour weights obtained using the methods described above will comprise non-zero values for every colour. For example, some level sensors can measure with up to 24 illumination settings (e.g., 12 wavelengths and two polarizations), and as such the methods disclosed herein may determine 24 colour weights.

In an embodiment, it may be advantageous to place a restriction on the number of colour weights used in the solution, e.g., to restrict the number of colours used for a measurement (e.g., up to a maximum of 4, 5, 6 or 7 colours). Advantages of such an embodiment comprise more robustness against overfitting on outliers in the training data, and less strict requirements on the future wafers on which the recipe will be applied, since all colours with non-zero weight must also be valid (e.g., sufficient signal strength). The number of colour weights in the solution may be restricted as taught in WO 2022/184405, which is hereby incorporated by reference in its entirety herein.

The method may comprise obtaining the height data (i.e. the data relating to height measurements). The height measurement can be obtained using actinic radiation. Obtaining the height data may comprise exposing a substrate to radiation from a source (e.g. from radiation source LSO).

As described above, the colour recipe may include colour tuning. Colour tuning steps relate to adapting the radiation used for obtaining the measurements, i.e. is pre-processing.

The method may further comprise comprises filtering the radiation (e.g. the actinic radiation). The method may comprise filtering radiation from the source to cut off radiation having a wavelength above a threshold value. In other words, a beam of radiation LSB may be filtered so that only radiation having a wavelength below the threshold value is used for obtaining the height data. The threshold value may be selected to improve the height process dependency (HPD). The threshold value may be selected/adapted for a given number of substrates. The threshold value may be approximately 200-800 nm, or preferably 250-700 nm, or more preferably 250-350 nm. The threshold value may be based on separate additional measurements of exposed substrates, which may, for example, be carried out infrequently, for example once per lot.

The method described in any of the above embodiments or variations may be performed by at least one sensor, e.g. at least one of the sensors described herein, such as the level sensor. The methods may obtain (at least initial correction weights) based on the using only height data obtained from the at least one sensor. Thus, the present invention may provide a level sensor operable to perform the method disclosed herein. The present invention may provide a lithographic apparatus, such as the lithographic apparatus described above, comprising such a sensor, e.g. comprising the level sensor, so as to perform the method disclosed herein. The lithographic apparatus may comprise any relevant components, such as those described above in relation to figure 1. The lithographic apparatus may comprise the patterning device support MT for supporting a patterning device MA and a substrate support WT for supporting a substrate.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. The method of the present invention may be at least partially computer-implemented. Embodiments of the invention may also be implemented as instructions stored on a machine-readable medium, which may be read and executed by one or more processors. The present invention may provide a computer program comprising instructions operable to perform the method described herein (in any of the embodiments or variations described herein). The computer program may be stored on a machine-readable medium. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. The present invention may provide a processing system comprising a processor and a storage device comprising the computer program operable to perform the method described herein. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Exemplary embodiments of the invention are set out in the following numbered clauses:

1. A method for determining a set of correction weights to correct data relating to height measurements of a substrate comprising a plurality of fields to be exposed, the method comprising:

obtaining height data relating to a plurality of illumination settings of measurement radiation used to perform a measurement, where each illumination setting comprises a different wavelength, polarization, angle of incidence, or any combination thereof; and
determining at least one of:

a) one or more correction weights to minimize variation of intrafield height data, and/or
b) one or more correction weights such that the height data for a plurality of fields is largely equivalent.

2. The method of clause 1, wherein determining the one or more correction weights comprises:

fitting the height data for each illumination setting to a model for representing the height data;
determining the fit residuals; and
determining said correction weights as correction weights which minimize the fit residuals.

3. The method of either of clauses 1 or 2, further comprising obtaining intensity data for each of the illumination settings and using the intensity data for determining the one or more correction weights.

4. The method of any one of the preceding clauses, wherein minimizing variation of the intrafield height data comprises obtaining an average of the height data for across the plurality of fields, and determining the one or more correction weights for the average of the height data.

5. The method of any one of the preceding clauses, wherein determining one or more correction weights such that the height data across the plurality of fields is largely equivalent comprises using height data for the plurality of fields and determining the one or more correction weights across the plurality of fields, wherein the method comprises calculating a reference field based on a map of the height data across the plurality of fields, and the height data for the plurality of fields is adjusted by subtracting the reference field from each of the plurality of fields.

6. The method of clause 5, wherein the reference field is an average field.

7. The method of any preceding clause, wherein the method comprises determining one or more first correction weights to minimize variation of the intrafield height data, and determining one or more second correction weights such that variation of the height data across the plurality of fields is largely equivalent, and determining one or more third correction weights based on a weighted sum of the first and second correction weights.

8. The method of any one of the preceding clauses, wherein the one or more first correction weights are an initial set of correction weights, and the method comprises obtaining additional height data from further substrates to update the initial correction weights to provide one or more adjusted correction weights.

9. The method of any one of the preceding clauses, wherein reference correction weights are obtained from reference data, and the correction weights determined in any one of the preceding clauses are combined with the reference correction weights based on a weighted sum to transition from the determined correction weights to the reference correction weights.

10. The method of any one of the preceding clauses, wherein the height measurement is obtained using actinic radiation.

11. The method of any one of the preceding clauses, wherein determining an initial set of the one or more correction weights does not rely on any reference measurements.

12. The method of any preceding clause, wherein the method comprises an initial step of removing data corresponding to a shape of the substrate from the height data.

13. The method of any one of the preceding clauses, wherein obtaining the height data comprises exposing a substrate to radiation from a source, and the method comprises filtering radiation from the source to cut off radiation having a wavelength above a threshold value.

14. The method of clause 13, wherein the threshold value is approximately 200-800 nm, 250-700 nm, or more preferably 250-350 nm.

15. A level sensor operable to perform the method of any one of clauses 1 to 14.

16. A lithographic apparatus comprising:

a patterning device support for supporting a patterning device;

a substrate support for supporting a substrate; and
the level sensor of clause 15.

17. A computer program comprising program instructions operable to perform the method of any one of clauses 1 to 14.
18. A processing system comprising a processing and a storage device comprising the computer program of clause 17.

**Claims**

1.  A method for determining a set of correction weights to correct data relating to height measurements of a substrate comprising a plurality of fields to be exposed, the method comprising:

    obtaining height data relating to a plurality of illumination settings of measurement radiation used to perform a measurement, where each illumination setting comprises a different wavelength, polarization, angle of incidence, or any combination thereof; and
    determining at least one of:

    c) one or more correction weights to minimize variation of intrafield height data, and/or
    d) one or more correction weights such that the height data for a plurality of fields is largely equivalent.

2.  The method of claim 1, wherein determining the one or more correction weights comprises:

    fitting the height data for each illumination setting to a model for representing the height data;
    determining the fit residuals; and
    determining said correction weights as correction weights which minimize the fit residuals.

3.  The method of either of claims 1 or 2, further comprising obtaining intensity data for each of the illumination settings and using the intensity data for determining the one or more correction weights.

4.  The method of any one of the preceding claims, wherein minimizing variation of the intrafield height data comprises obtaining an average of the height data for across the plurality of fields, and determining the one or more correction weights for the average of the height data.

5.  The method of any one of the preceding claims, wherein determining one or more correction weights such that the height data across the plurality of fields is largely equivalent comprises using height data for the plurality of fields and determining the one or more correction weights across the plurality of fields, wherein the method comprises calculating a reference field based on a map of the height data across the plurality of fields, and the height data for the plurality of fields is adjusted by subtracting the reference field from each of the plurality of fields.

6.  The method of claim 5, wherein the reference field is an average field.

7.  The method of any preceding claim, wherein the method comprises determining one or more first correction weights to minimize variation of the intrafield height data, and determining one or more second correction weights such that variation of the height data across the plurality of fields is largely equivalent, and determining one or more third correction weights based on a weighted sum of the first and second correction weights.

8.  The method of any one of the preceding claims, wherein the one or more first correction weights are an initial set of correction weights, and the method comprises obtaining additional height data from further substrates to update the initial correction weights to provide one or more adjusted correction weights.

9.  The method of any one of the preceding claims, wherein reference correction weights are obtained from reference data, and the correction weights determined in any one of the preceding claims are combined with the reference correction weights based on a weighted sum to transition from the determined correction weights to the reference correction weights.

10. The method of any one of the preceding claims, wherein determining an initial set of the one or more correction weights does not rely on any reference measurements.

11. The method of any preceding claim, wherein the method comprises an initial step of removing data corresponding to a shape of the substrate from the height data.

12. The method of any one of the preceding claims, wherein obtaining the height data comprises exposing a substrate to radiation from a source, and the method comprises filtering radiation from the source to cut off radiation having a wavelength above a threshold value.

13. A level sensor operable to perform the method of any one of claims 1 to 12.

14. A lithographic apparatus comprising:

a patterning device support for supporting a patterning device;
a substrate support for supporting a substrate; and
the level sensor of claim 13.

15. A computer program comprising program instructions operable to perform the method of any one of claims 1 to 14.

# Fig. 1

# Fig. 2

Fig. 3

Europäisches
Patentamt

European
Patent Office

Office européen
des brevets

## EUROPEAN SEARCH REPORT

**Application Number**

**EP 25 15 4435**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/245892 A1 (ASML NETHERLANDS BV [NL]) 5 December 2024 (2024-12-05)<br>* figures 1, 3-5 *<br>* paragraph [0065] - paragraph [0077] *<br>* paragraph [0086] *<br>* paragraph [0105] *<br>* paragraph [0113] - paragraph [0117] *<br>----- | 1,10,11, 13-15 | INV.<br>G03F9/00 |
| X | US 2013/128247 A1 (KHUAT DUY LAURENT [NL] ET AL) 23 May 2013 (2013-05-23)<br>* figures 2, 5 *<br>* paragraph [0068] *<br>* paragraph [0070] - paragraph [0071] *<br>* paragraph [0110] - paragraph [0113] *<br>----- | 1,10,11, 13-15 | |
| X,D<br>Y<br>A | US 2019/094721 A1 (TINNEMANS PATRICIUS ALOYSIUS JACOBUS [NL] ET AL) 28 March 2019 (2019-03-28)<br>* figures 3-6 *<br>* paragraph [0064] *<br>* paragraphs [0079] - [0082] *<br>* paragraphs [0107] - [0109] *<br>----- | 1,10,11, 13-15<br>2-6,12<br>7-9 | |
| Y<br>A | WO 2024/099744 A1 (ASML NETHERLANDS BV [NL]) 16 May 2024 (2024-05-16)<br>* paragraph [0006] *<br>* paragraph [0046] - paragraph [0055] *<br>* paragraph [0059] *<br>* paragraph [0069] *<br>----- | 2-6,12<br>7-9 | |

**TECHNICAL FIELDS SEARCHED (IPC)**

G03F

The present search report has been drawn up for all claims

| Place of search | Date of completion of the search | Examiner |
|---|---|---|
| Munich | 12 August 2025 | Philipp, Peter |

EPO FORM 1503 03.82 (P04C01)

## ANNEX TO THE EUROPEAN SEARCH REPORT
## ON EUROPEAN PATENT APPLICATION NO.

EP 25 15 4435

This annex lists the patent family members relating to the patent documents cited in the above-mentioned European search report.
The members are as contained in the European Patent Office EDP file on
The European Patent Office is in no way liable for these particulars which are merely given for the purpose of information.

12-08-2025

| Patent document cited in search report | Publication date | Patent family member(s) | | Publication date |
|---|---|---|---|---|
| WO 2024245892 A1 | 05-12-2024 | TW | 202514286 A | 01-04-2025 |
| | | WO | 2024245892 A1 | 05-12-2024 |
| US 2013128247 A1 | 23-05-2013 | JP | 5667145 B2 | 12-02-2015 |
| | | JP | 2013110398 A | 06-06-2013 |
| | | US | 2013128247 A1 | 23-05-2013 |
| US 2019094721 A1 | 28-03-2019 | EP | 3504593 A1 | 03-07-2019 |
| | | EP | 3627228 A1 | 25-03-2020 |
| | | TW | 201921100 A | 01-06-2019 |
| | | TW | 202046009 A | 16-12-2020 |
| | | US | 2019094721 A1 | 28-03-2019 |
| | | US | 2020081356 A1 | 12-03-2020 |
| | | US | 2020272061 A1 | 27-08-2020 |
| | | WO | 2019063245 A1 | 04-04-2019 |
| WO 2024099744 A1 | 16-05-2024 | CN | 119487446 A | 18-02-2025 |
| | | KR | 20250107122 A | 11-07-2025 |
| | | TW | 202435002 A | 01-09-2024 |
| | | WO | 2024099744 A1 | 16-05-2024 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 7265364 B
- US 7646471 B
- US 2010233600 A1
- WO 2016102127 A
- US 20190094721 A1
- WO 2022184405 A